# EUROPEAN PATENT SPECIFICATION

(11) **EP 4 468 366 B1**
(45) Date of publication and mention of the grant of the patent: **25.02.2026**
(21) Application number: 24155654.7
(22) Date of filing: 20.02.2024
(51) Int. Cl.: H10D 30/47, H10D 64/00, H10D 64/23, H10D 64/27, H10D 30/01, H10D 62/85

(54) **SEMICONDUCTOR DEVICE AND METHOD FOR MANUFACTURING THE SAME**
HALBLEITERVORRICHTUNG UND VERFAHREN ZU DEREN HERSTELLUNG
DISPOSITIF SEMI-CONDUCTEUR ET SON PROCÉDÉ DE FABRICATION

(30) Priority: 22.05.2023 JP 2023083719
(43) Date of publication of application: 27.11.2024
(73) Proprietor: Kabushiki Kaisha Toshiba, Tokyo 105-0023 (JP); Toshiba Electronic Devices & Storage Corporation, Tokyo 105-0023 (JP)
(72) Inventor: TAJIMA, Jumpei, Tokyo (JP); HUANG, Po-Chin, Tokyo (JP); SHINDOME, Aya, Tokyo (JP); KAJIWARA, Yosuke, Tokyo (JP); HIKOSAKA, Toshiki, Tokyo (JP); KURAGUCHI, Masahiko, Tokyo (JP)
(74) Representative: Kramer Barske Schmidtchen Patentanwälte PartG mbB

(56) References cited:
- US-A1- 2011 018 002
- US-A1- 2017 033 187
- US-A1- 2020 303 533
- US-A1- 2020 335 587
- YANG CHAO ET AL: "High Breakdown Voltage and Low Dynamic ON-Resistance AlGaN/GaN HEMT with Fluorine Ion Implantation in SiNx Passivation Layer", vol. 14, no. 1, 1 December 2019 (2019-12-01), US, XP093204324, ISSN: 1931-7573, Retrieved from the Internet <URL:https://link.springer.com/content/pdf/10.1186/s11671-019-3025-8.pdf> DOI: 10.1186/s11671-019-3025-8

## Description

### FIELD

Embodiments described herein generally relate to a semiconductor device and a method for manufacturing the same device.

### BACKGROUND

US 2011/0018002 A1 discloses a semiconductor device according to the preamble of claim 1 and a method of manufacturing such a semiconductor device. US 2020303533 A1 discloses another semiconductor device according to the preamble of claim 1. US 2017/033187 A1 and US 2020/335587 A1 disclose further semiconductor devices. "High Breakdown Voltage and Low Dynamic ON-Resistance AlGaN/GaN HEMT with Fluorine Ion Implantation in SiNx Passivation Layer" by Yang et al., Nanoscale Research Letters (2019),14:191, furthermore discloses a method of introducing fluorine into a barrier layer of a HEMT from a dielectric layer. For example, in semiconductor devices, improvement in characteristics is desired.

This object is achieved by a semiconductor device according to claim 1 or a method of manufacturing a semiconductor device according to claim 13 or 14. Further developments are given in the dependent claims.

### BRIEF DESCRIPTION OF THE DRAWINGS

FIG. 1 is a schematic plan view illustrating a semiconductor device according to a first embodiment;
FIG. 2 is a schematic cross-sectional view illustrating the semiconductor device according to the first embodiment;
FIG. 3 is a schematic cross-sectional view illustrating a part of the semiconductor device according to the first embodiment;
FIG. 4 is a schematic cross-sectional view illustrating a part of a semiconductor device according to the first embodiment;
FIG. 5 is a schematic cross-sectional view illustrating a part of a semiconductor device according to the first embodiment;
FIG. 6 is a schematic cross-sectional view illustrating a part of a semiconductor device according to the first embodiment;
FIG. 7 is a schematic cross-sectional view illustrating a part of a semiconductor device according to the first embodiment;
FIG. 8 is a schematic cross-sectional view illustrating a part of a semiconductor device according to the first embodiment;
FIG. 9 is a schematic cross-sectional view illustrating a semiconductor device according to the first embodiment;
FIG. 10 is a schematic cross-sectional view illustrating a semiconductor device according to the first embodiment;
FIGS. 11A and 11B are schematic cross-sectional views illustrating a method for manufacturing a semiconductor device according to a second embodiment; and
FIGS. 12A and 12B are schematic cross-sectional views illustrating a method for manufacturing a semiconductor device according to the second embodiment.

### DETAILED DESCRIPTION

Various embodiments are described below with reference to the accompanying drawings.

The drawings are schematic and conceptual; and the relationships between the thickness and width of portions, the proportions of sizes among portions, etc., are not necessarily the same as the actual values. The dimensions and proportions may be illustrated differently among drawings, even for identical portions.

In the specification and drawings, components similar to those described previously in an antecedent drawing are marked with like reference numerals, and a detailed description is omitted as appropriate.

### (First Embodiment)

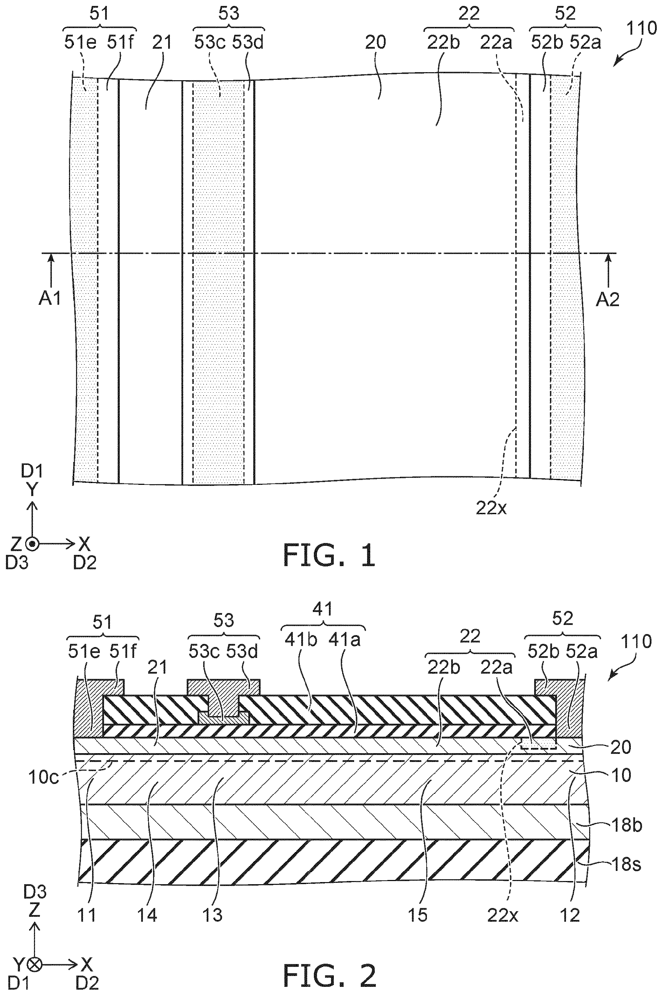

FIG. 1 is a schematic plan view illustrating a semiconductor device according to a first embodiment.

FIG. 2 is a schematic cross-sectional view illustrating the semiconductor device according to the first embodiment.

FIG. 2 is a cross-sectional view taken along the line A1-A2 of FIG. 1.

As shown in FIGS. 1 and 2, a semiconductor device 110 according to the embodiment includes a first electrode 51, a second electrode 52, a third electrode 53, a first semiconductor region 10 and a second semiconductor region 20.

As shown in FIG. 1, the first electrode 51, the second electrode 52, and the third electrode 53 extend in a first direction D1. A second direction D2 from the first electrode 51 to the second electrode 52 is perpendicular to the first direction D1.

The first direction D1 is a Y-axis direction. One direction perpendicular to the Y-axis direction is defined as an X-axis direction. A direction perpendicular to the Y-axis direction and the X-axis direction is defined as a Z-axis direction. For example, the second direction D2 is the X-axis direction.

A length of the first electrode 51 in the first direction D1 is longer than a length (width) of the first electrode 51 in the second direction D2. A length of the second electrode 52 in the first direction D1 is longer than a length (width) of the second electrode 52 in the second direction D2. A length of the third electrode 53 in the first direction D1 is longer than a length (width) of the third electrode 53 in the second direction D2. The first electrode 51, the second electrode 52 and the third electrode 53 are stripes extending in the first direction.

A position of the third electrode 53 in the second direction D2 is between a position of the first electrode 51 in the second direction D2 and a position of the second electrode 52 in the second direction D2.

The first semiconductor region 10 includes Alₓ₁Ga₁₋ₓ₁N (0 ≤ x1 < 1). The composition ratio x1 is, for example, not less than 0 and not more than 0.1. The first semiconductor region 10 is, for example, a GaN layer.

As shown in FIG. 2, the first semiconductor region 10 includes a first partial region 11, a second partial region 12, a third partial region 13, a fourth partial region 14 and a fifth partial region 15. A third direction D3 from the first partial region 11 to the first electrode 51 crosses a plane including the first direction D1 and the second direction D2. The third direction D3 is, for example, the Z-axis direction.

A direction from the second partial region 12 to the second electrode 52 is along the third direction D3. A direction from the third partial region 13 to the third electrode 53 is along the third direction D3. The first partial region 11 overlaps the first electrode 51 in the third direction D3. The second partial region 12 overlaps the second electrode 52 in the third direction D3. The third partial region 13 overlaps the third electrode 53 in the third direction D3.

A position of the fourth partial region 14 in the second direction D2 is between a position of the first partial region 11 in the second direction D2 and a position of the third partial region 13 in the second direction D2. A position of the fifth partial region 15 in the second direction D2 is between a position of the third partial region 13 in the second direction D2 and a position of the second partial region 12 in the second direction D2.

The second semiconductor region 20 includes Alₓ₂Ga₁₋ₓ₂N (0 < x2 < 1, x1 < x2). The composition ratio x2 is, for example, not less than 0.2 and not more than 0.35. The second semiconductor region 20 is, for example, an AlGaN layer. The second semiconductor region 20 includes a first semiconductor portion 21 and a second semiconductor portion 22. A direction from the fourth partial region 14 to the first semiconductor portion 21 is along the third direction D3. A direction from the fifth partial region 15 to the second semiconductor portion 22 is along the third direction D3.

The second semiconductor portion 22 includes a first region 22a and a second region 22b. A position of the first region 22a in the second direction D2 is between a position of the second region 22b in the second direction D2 and a position of the second electrode 52 in the second direction D2. A concentration of fluorine in the first region 22a is higher than a concentration of fluorine in the second region 22b. Alternatively, the first region 22a includes fluorine and the second region 22b does not include fluorine.

For example, a current flowing between the first electrode 51 and the second electrode 52 can be controlled by a potential of the third electrode 53. The potential of the third electrode 53 may be based on a potential of the first electrode 51. For example, the first electrode 51 functions as a source electrode. For example, the second electrode 52 functions as a drain electrode. For example, the third electrode 53 functions as a gate electrode. The semiconductor device 110 is, for example, a transistor.

As shown in FIG. 2, the first semiconductor region 10 includes a portion facing the second semiconductor region 20. A carrier region 10c is formed in this portion. The carrier region 10c is, for example, a two-dimensional electron gas. The semiconductor device 110 is, for example, a HEMT (High Electron Mobility Transistor).

For example, the distance between the first electrode 51 and the third electrode 53 in the second direction D2 is shorter than the distance between the third electrode 53 and the second electrode 52 in the second direction D2. More stable characteristics can be obtained.

In the embodiments, a voltage applied to the second electrode 52 is higher than a voltage applied to the third electrode 53. Therefore, a high electric field is concentrated in a region near the second electrode 52, and the operation tends to become unstable. For example, traps are likely to be generated due to the high electric field generated at the end of the second electrode 52. This makes it easier for the characteristics to change, for example. For example, current collapse may occur.

In the embodiment, as described above, the first region 22a close to the second electrode 52 include fluorine. For example, when fluorine is present in the first region 22a, the generation of traps is suppressed. This makes it easier to maintain stable characteristics even when a high electric field is concentrated in a region close to the second electrode 52. For example, current collapse is suppressed. According to the embodiment, a semiconductor device with improved characteristics can be provided.

In the embodiments, the second region 22b having a low concentration of fluorine or including no fluorine is provided. For example, it is easier to maintain a lower on-resistance than when all of the second semiconductor portion 22 between the third electrode 53 and the second electrode 52 includes fluorine. According to the embodiment, for example, stable characteristics and low on-resistance can be obtained.

In one example according to the embodiment, the concentration of fluorine in the first region 22a is not less than 1×10¹⁶ cm⁻³ and not more than 1×10¹⁸ cm⁻³. Traps can be suppressed more stably. On the other hand, the concentration of fluorine in the second region 22b is less than 1×10¹⁶ cm⁻³. Low on-resistance is stable and easy to obtain.

In one example, the first region 22a and the second region 22b having different concentrations of fluorine are obtained by selectively introducing fluorine into the second semiconductor region 20 using a mask, or the like.

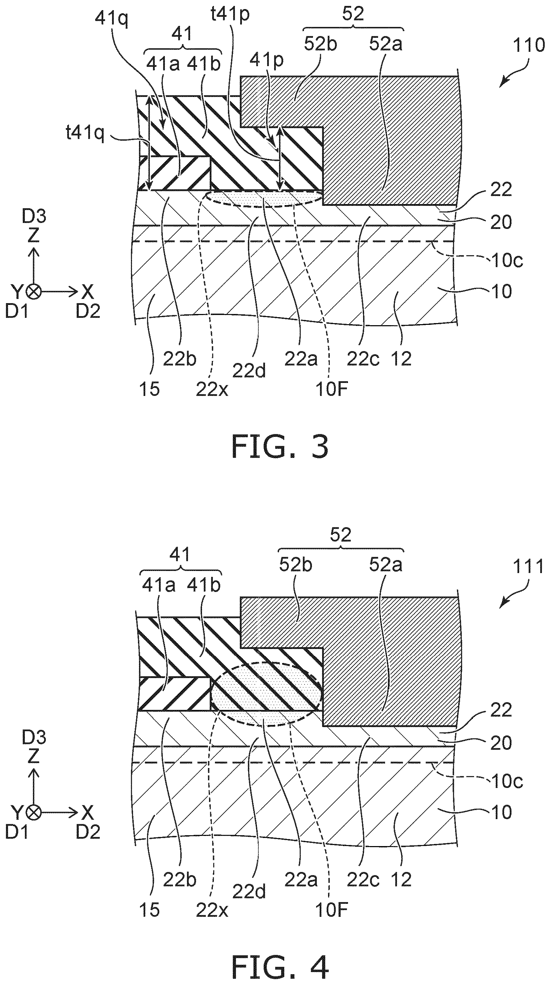

FIG. 3 is a schematic cross-sectional view illustrating a part of the semiconductor device according to the first embodiment.

FIG. 3 shows an enlarged example of a part of the semiconductor device 110 that includes the second electrode 52.

As shown in FIG. 3, the second electrode 52 includes a first electrode portion 52a and a second electrode portion 52b. A direction from the first region 22a to at least a part of the first electrode portion 52a is along the second direction D2. At least a part of the first region 22a is located between the first semiconductor region 10 and the second electrode portion 52b in the third direction D3. The first electrode portion 52a is electrically connected to the second partial region 12 (and the second semiconductor portion 22).

For example, the second electrode portion 52b is an eaves portion. The second electrode portion 52b may function as a field plate on the drain side. A high electric field tends to occur locally at the end of the second electrode portion 52b. By providing the first region 22a including fluorine under the second electrode portion 52b, the characteristics become more stable.

In FIG. 3, a region 10F surrounded by a broken line includes fluorine. At least a part of the first region 22a is included in the region 10F. As shown in FIGS. 1 and 3, the boundary 22x between the second region 22b and the first region 22a is located between the third electrode 53 and the second electrode 52. The position of the boundary 22x in the second direction D2 is between the position of the third electrode 53 in the second direction D2 and the position of the second electrode portion 52b in the second direction D2. For example, at least part of the first region 22a does not overlap the second electrode portion 52b in the third direction D3. A high electric field tends to concentrate at the end of the second electrode portion 52b on the third electrode 53 side. By the position of the boundary 22x being on the side of the third electrode 53, it is possible to more stably suppress traps that cause changes in characteristics. It is easier to obtain stable characteristics.

As shown in FIG. 3, in this example, no region including fluorine is provided under the first electrode portion 52a. For example, the second semiconductor portion 22 may further include a third region 22c. The third region 22c is located between the second partial region 12 and the first electrode portion 52a in the third direction D3. The concentration of fluorine in the third region 22c is lower than the concentration of fluorine in the first region 22a. Alternatively, the third region 22c does not include fluorine. For example, low contact resistance can be obtained because the region overlapping the first electrode portion 52a does not include fluorine. This makes it easier to obtain low on-resistance.

As shown in FIG. 3, the second semiconductor portion 22 may further include a fourth region 22d. The fourth region 22d is located between the first semiconductor region 10 and the first region 22a in the third direction D3. The concentration of fluorine in the fourth region 22d is lower than the concentration of fluorine in the first region 22a. Alternatively, the fourth region 22d does not include fluorine.

For example, a region with a high fluorine concentration (first region 22a) may be locally provided on the surface side of the second semiconductor portion 22. Traps that affect the characteristics tend to occur on the surface side of the second semiconductor portion 22. By locally providing a region with a high fluorine concentration (first region 22a) on the surface side of the second semiconductor portion 22, changes in characteristics can be effectively suppressed. By providing the fourth region 22d with a low fluorine concentration, for example, low on-resistance can be easily obtained.

As shown in FIG. 3, the semiconductor device 110 may further include a first insulating member 41. At least a part of the first insulating member 41 is located between the first region 22a and the second electrode portion 52b.

A portion 41p of the first insulating member 41 is located between the first region 22a and the second electrode portion 52b. Another portion 41q of the first insulating member 41 does not overlap the second electrode 52 in the third direction D3. The thickness along the third direction D3 of the portion 41p of the first insulating member 41 is defined as a thickness t41p. The thickness along the third direction D3 of the other portion 41q of the first insulating member 41 is defined as a thickness t41q. The thickness t41p is thinner than the thickness t41q. The portion 41p of the first insulating member 41 overlaps the first region 22a. Even when such a difference in thickness is provided, stable characteristics can be effectively obtained by providing the first region 22a.

In this example, the first insulating member 41 includes a first insulating portion 41a and a second insulating portion 41b. At least part of the first insulating portion 41a is located between the second semiconductor portion 22 and the second insulating portion 41b in the third direction D3. The first insulating portion 41a does not overlap the second electrode portion 52b in the third direction D3. A part of the second insulating portion 41b is located between the first region 22a and the second electrode portion 52b in the third direction D3. This part of the second insulating portion 41b is located between the first insulating portion 41a and the first electrode portion 52a in the second direction D2. In this way, a stacked structure may be applied to the first insulating member 41.

In one example, the first insulating portion 41a can be formed by CVD (for example, LPCVD: Low-Pressure Chemical Vapor Deposition). The second insulating portion 41b can be formed, for example, by CVD (for example, PECVD: plasma-enhanced chemical vapor deposition). For example, the film quality of the first insulating portion 41a is higher than the film quality of the second insulating portion 41b. It is easier to obtain more stable characteristics. The first insulating member 41 (the first insulating portion 41a and the second insulating portion 41b) may include silicon and nitrogen, for example. The first insulating portion 41a and the second insulating portion 41b include, for example, silicon nitride. It is easy to obtain stable characteristics. The first insulating member 41 (the first insulating portion 41a and the second insulating portion 41b) may include silicon and oxygen, for example.

As shown in FIG. 2, a part of the first insulating portion 41a may be provided between the second semiconductor region 20 and the third electrode 53 in the third direction D3. This part of the first insulating portion 41a overlaps the third electrode 53 in the third direction D3. This part of the first insulating portion 41a functions as, for example, a gate insulating film.

As shown in FIG. 2, in this example, the third electrode 53 includes a third electrode portion 53c and a fourth electrode portion 53d. In this example, the third electrode portion 53c is in contact with a part of the first insulating portion 41a. The fourth electrode portion 53d is electrically connected to the third electrode portion 53c. The fourth electrode portion 53d is, for example, an eaves portion.

As shown in FIG. 2, in this example, the first electrode 51 includes a fifth electrode portion 51e and a sixth electrode portion 51f. The fifth electrode portion 51e is electrically connected to the first partial region 11 (and the first semiconductor portion 21). The sixth electrode portion 51f is electrically connected to the fifth electrode portion 51e. The sixth electrode portion 51f is, for example, an eaves portion.

As shown in FIG. 2, the semiconductor device 110 may include a base 18s and a nitride layer 18b. The first semiconductor region 10 is provided between the base 18 s and the second semiconductor region 20. The nitride layer 18b is provided between the base 18s and the first semiconductor region 10. The base 18s may be, for example, a silicon substrate. The nitride layer 18b includes, for example, Al, Ga, and nitrogen. The nitride layer 18b includes AlGaN, for example. This AlGaN layer is, for example, a buffer layer. The nitride layer 18b includes a region facing the first semiconductor region 10. This region may include a GaN layer including carbon.

For example, in a first sample including the configuration illustrated in FIG. 3, the on-resistance after the voltage stress test is three times the initial value before the voltage stress test. In a second sample in which the first region 22a is not provided, the on-resistance after the voltage stress test is six times the initial value before the voltage stress test. By providing the first region 22a, the change in on-resistance is reduced to 1/2. In the voltage stress test, a drain voltage of the rated voltage is applied for 1000 seconds in a state of the gate off.

Hereinafter, some examples of various configurations of the region including the second electrode will be described.

FIG. 4 is a schematic cross-sectional view illustrating a part of a semiconductor device according to the first embodiment.

As shown in FIG. 4, in a semiconductor device 111 according to the embodiment, the first insulating member 41 includes the first insulating portion 41a and the second insulating portion 41b. A part of the second insulating portion 41b is located between the first region 22a and the second electrode portion 52b in the third direction D3. The fluorine concentration in this part of the second insulating portion 41b is higher than the fluorine concentration in the first insulating portion 41a. Alternatively, this portion of the second insulating portion 41b includes fluorine and the first insulating portion 41a does not include fluorine. Thus, the second insulating portion 41b overlapping the first region 22a may include fluorine. The first region 22a including fluorine can be stably obtained easily. In one example, fluorine may be supplied to the first region 22a from the second insulating portion 41b including fluorine.

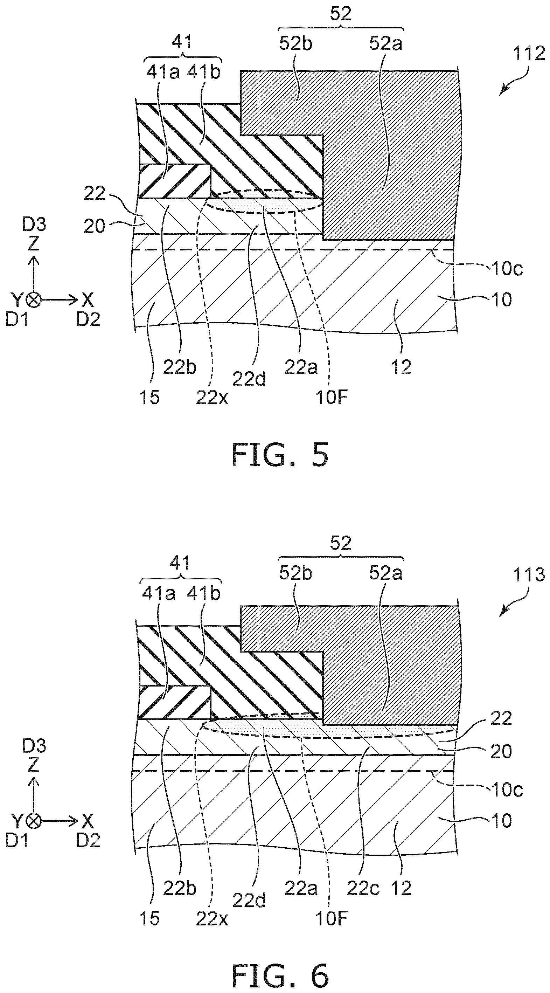

FIG. 5 is a schematic cross-sectional view illustrating a part of a semiconductor device according to the first embodiment.

As shown in FIG. 5, in a semiconductor device 112 according to the embodiment, the second partial region 12 is in contact with the first electrode portion 52a. A direction from the second semiconductor portion 22 to at least a part of the first electrode portion 52a is along the second direction D2. Also in such a semiconductor device 112, the first region 22a including fluorine is provided.

FIG. 6 is a schematic cross-sectional view illustrating a part of a semiconductor device according to the first embodiment.

As shown in FIG. 6, in a semiconductor device 113 according to the embodiment, a part of the first region 22a is provided between the second partial region 12 and the first electrode portion 52a in the third direction D3. In this way, the first region 22a including fluorine may be provided also under the first electrode portion 52a.

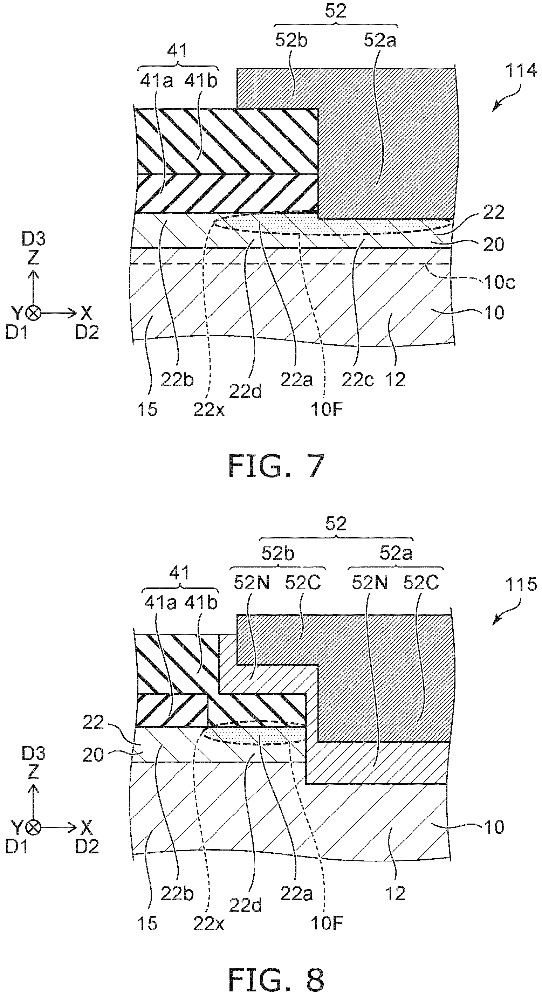

FIG. 7 is a schematic cross-sectional view illustrating a part of a semiconductor device according to the first embodiment.

As shown in FIG. 7, in a semiconductor device 114 according to the embodiment, the first region 22a may be provided between the first semiconductor region 10 and the first insulating portion 41a.

Other configurations described with respect to the semiconductor device 110 may be applied to the semiconductor devices 111 to 114 described above.

FIG. 8 is a schematic cross-sectional view illustrating a part of a semiconductor device according to the first embodiment.

As shown in FIG. 8, in a semiconductor device 115 according to the embodiment, the second electrode 52 includes a nitride region 52N and a conductive region 52C. A part of the nitride region 52N is provided between the second partial region 12 and the conductive region 52C. Another part of the nitride region 52N is provided between a part of the second insulating portion 41b and the second electrode portion 52b. The material of nitride region 52N is different from the material of conductive region 52C.

For example, the nitride region 52N includes gallium and nitrogen. The nitride region 52N is n-type GaN. The conductive region 52C is, for example, metal. In this way, a part of the second electrode 52 may include a semiconductor. For example, it becomes easier to obtain lower on-resistance.

Also in the semiconductor device 115, the first region 22a including fluorine is provided. Stable characteristics can be obtained. In the semiconductor device 115, the configuration described with respect to the semiconductor devices 110 to 114 may be applied.

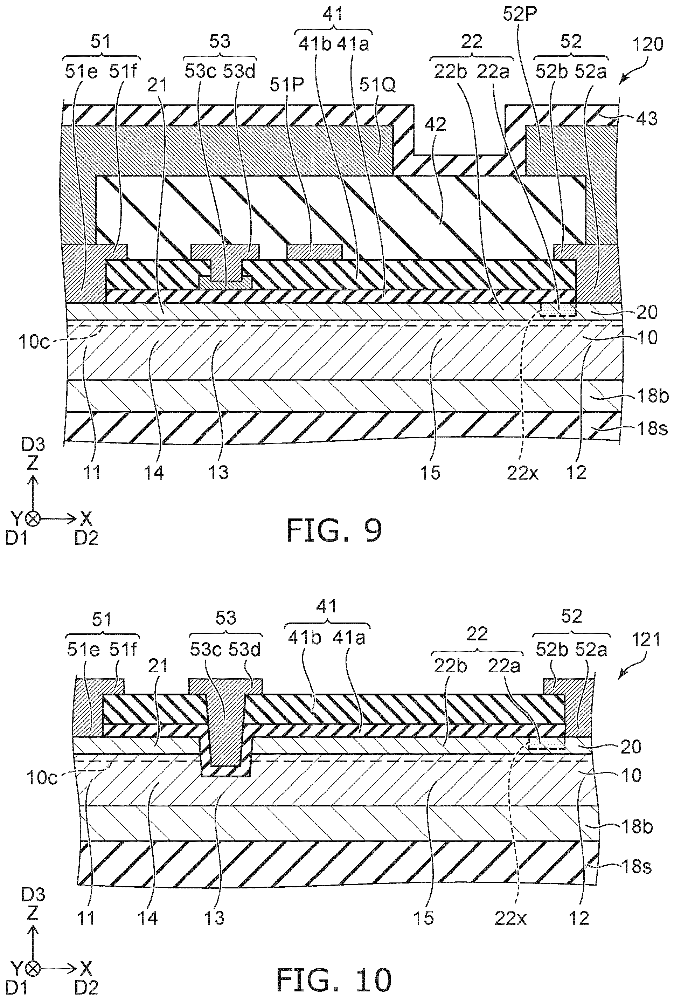

FIG. 9 is a schematic cross-sectional view illustrating a semiconductor device according to the first embodiment.

As shown in FIG. 9, a semiconductor device 120 according to the embodiment includes a second electrode conductive member 52P, the first insulating member 41, and a second insulating member 42. The configurations of the semiconductor devices 110 to 115 may be applied to the configurations excluding the second electrode conductive member 52P and the second insulating member 42.

In semiconductor device 120, second electrode conductive member 52P is electrically connected to second electrode 52. At least a part of the first insulating member 41 is provided between the second semiconductor portion 22 and the second electrode portion 52b. At least a part of the second insulating member 42 is provided between the second electrode portion 52b and the second electrode conductive member 52P. The second electrode conductive member 52P functions, for example, as a field plate. The concentration of electric field is further relaxed.

The first insulating member 41 includes silicon and nitrogen. The second insulating member 42 includes silicon and oxygen. The concentration of nitrogen in the second insulating member 42 is lower than the concentration of nitrogen in the first insulating member 41. Alternatively, the second insulating member 42 does not include nitrogen. With such a plurality of insulating members, more stable characteristics can be easily obtained.

As shown in FIG. 9, a first electrode conductive member 51P may be provided. The first electrode conductive member 51P is electrically connected to the first electrode 51. In this example, the first electrode conductive member 51P is electrically connected to the first electrode 51 at a position different from the cross section shown in FIG.9. Another first electrode conductive member 51Q may be provided. The other first electrode conductive member 51Q is electrically connected to the first electrode 51.

For example, the second semiconductor portion 22 may include a region that overlaps the first electrode conductive member 51P. This region may include fluorine. Trap generation is further suppressed. This makes it easier to obtain stable characteristics.

As shown in FIG. 9, a third insulating member 43 may be provided on the second electrode conductive member 52P, the first electrode conductive member 51P, and the second insulating member. The third insulating member 43 may include, for example, silicon nitride.

FIG. 10 is a schematic cross-sectional view illustrating a semiconductor device according to the first embodiment.

As shown in FIG. 10, in a semiconductor device 121 according to the embodiment, at least a part of the third electrode 53 is provided between the first semiconductor portion 21 and the second semiconductor portion 22 in the second direction D2. For example, at least a part of the third electrode 53 is provided between the fourth partial region 14 and the fifth partial region 15 in the second direction D2. In the semiconductor device 121, the third electrode 53 is, for example, a recessed gate electrode. For example, a high threshold voltage can be obtained. Also in the semiconductor device 121, the first region 22a including fluorine is provided. Stable characteristics can be obtained.

In the semiconductor device 121, a part of the first insulating portion 41a is provided between the first semiconductor portion 21 and at least a part of the third electrode 53 in the second direction D2. Another part of the first insulating portion 41a is provided between at least a part of the third electrode 53 and the second semiconductor portion 22 in the second direction D2.

### (Second Embodiment)

The second embodiment relates to a method for manufacturing a semiconductor device. Below, a method of manufacturing a portion including the second electrode 52 will be described.

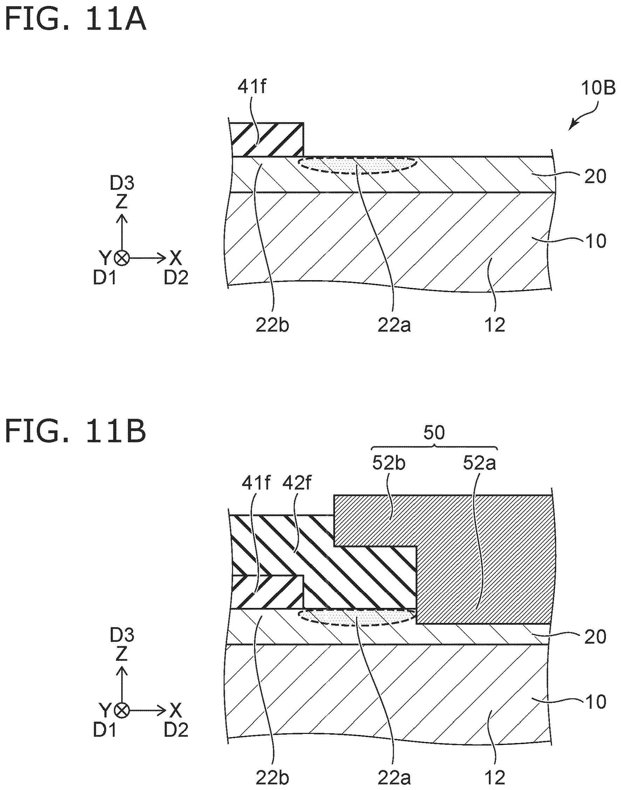

FIGS. 11A and 11B are schematic cross-sectional views illustrating a method for manufacturing a semiconductor device according to the second embodiment.

As shown in FIG. 11A, in a method for manufacturing a semiconductor device according to the embodiment, a structure body 10B is prepared.

The structure body 10B includes the first semiconductor region 10 including Alₓ₁Ga₁₋ₓ₁N (0 ≤ x1 < 1), the second semiconductor region 20 including Alₓ₂Ga₁₋ₓ₂N (0 < x2 < 1, x1 < x2), and a first insulating film 41f. The second semiconductor region 20 includes the first region 22a and the second region 22b. The second region 22b is located between the first semiconductor region 10 and the first insulating film 41f. The first region 22a is not covered with the first insulating film 41f.

As shown in FIG. 11A, fluorine is introduced into the first region 22a. For example, fluorine may be introduced by ion implantation using the first insulating film 41f as a mask. The concentration of fluorine in the first region 22a is higher than the concentration of fluorine in the second region 22b. Alternatively, the first region 22a includes fluorine and the second region 22b does not include fluorine.

As shown in FIG. 11B, an electrode 50 is formed. The electrode 50 includes the first electrode portion 52a and the second electrode portion 52b. The first electrode portion 52a is electrically connected to a part of the first semiconductor region 10. The second electrode portion 52b is electrically connected to the first electrode portion 52a. The second electrode portion 52b overlaps the first region 22a in a direction from the first semiconductor region 10 to the second semiconductor region 20 (the third direction D3).

Thus, for example, the semiconductor device 110 is obtained. According to the embodiments, it is possible to provide a method of manufacturing a semiconductor device capable of improving characteristics.

In the above, the electrode 50 corresponds to the second electrode 52. The first insulating film 41f corresponds to, for example, the first insulating portion 41a. The second insulating portion 41b may be formed before forming the electrode 50.

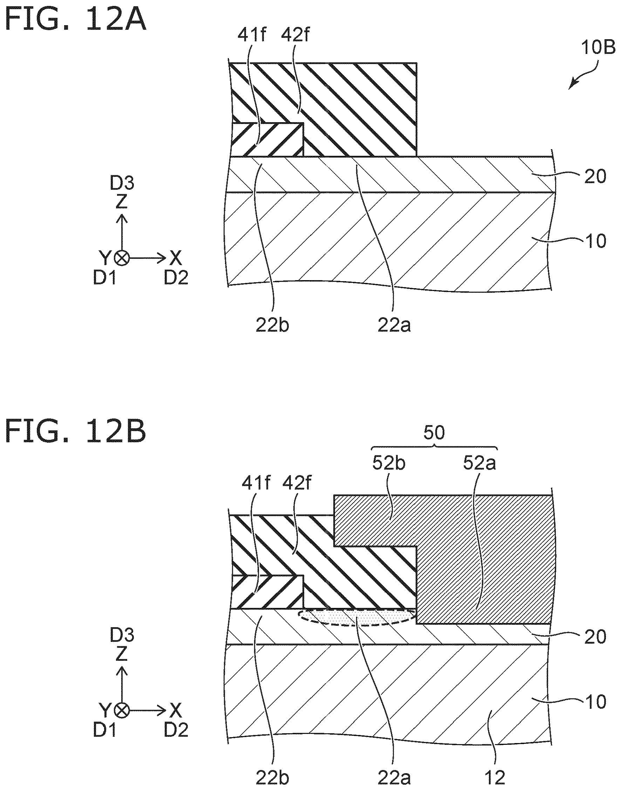

FIGS. 12A and 12B are schematic cross-sectional views illustrating a method for manufacturing a semiconductor device according to the second embodiment.

As shown in FIG. 12A, the structure body 10B is prepared in a method for manufacturing a semiconductor device according to the embodiment. In this example, the structure body 10B further includes a second insulating film 42f. The first insulating film 41f is provided between the second region 22b and a part of the second insulating film 42f. The first insulating film 41f is not provided between the first region 22a and the second insulating film 42f. The second insulating film 42f includes fluorine.

As shown in FIG. 12B, fluorine is moved from the second insulating film 42f to the first region 22a. For example, fluorine moves from the second insulating film 42f to the first region 22a by diffusion due to heat treatment or the like. Thereby, the first region 22a including fluorine is obtained. At this time, the movement of fluorine is suppressed by the first insulating film 41f. As a result, the concentration of fluorine in the second region 22b is low. Alternatively, the second region 22b does not substantially include fluorine.

Thus, introducing fluorine may include moving at least a part of the fluorine included in the second insulating film 42f to the first region 22a. For example, the semiconductor device 110 can be obtained by such a manufacturing method.

Information regarding length and thickness can be obtained by electron microscopy or the like. Information on the composition of materials can be obtained by SIMS (Secondary Ion Mass Spectrometry) or EDX (Energy dispersive X-ray spectroscopy).

According to the embodiments, a semiconductor device whose characteristics can be improved and a method for manufacturing the same are provided.

Hereinabove, exemplary embodiments of the invention are described with reference to specific examples.

However, the embodiments of the invention are not limited to these specific examples and the scope of the invention is defined by the claims.
For example, one skilled in the art may practice the invention by appropriately selecting specific configurations of components included in the semiconductor devices such as electrodes, semiconductor regions, insulating members, etc., from known art. Various other variations and modifications can be conceived by those skilled in the art within the scope of the invention defined by the claims.

## Claims

1. A semiconductor device, comprising:
a first electrode (51) extending in a first direction (D1);
a second electrode (52) extending in the first direction (D1), a second direction (D2) from the first electrode (51) to the second electrode (52) being perpendicular to the first direction (D1);
a third electrode (53) extending in the first direction (D1), a position of the third electrode (53) in the second direction (D2) being between a position of the first electrode (51) in the second direction (D2) and a position of the second electrode (52) in the second direction (D2);
a first semiconductor region (10) including Alₓ₁Ga₁₋ₓ₁N (0 ≤ x1 < 1), the first semiconductor region including a first partial region (11), a second partial region (12), a third partial region (13), a fourth partial region (14), and a fifth partial region (15), a third direction (D3) from the first partial region (11) to the first electrode (51) crossing a plane including the first direction (D1) and the second direction (D2), a direction from the second partial region (12) to the second electrode (52) being along the third direction (D3), a direction from the third partial region (13) to the third electrode (53) being along the third direction (D3), a position of the fourth partial region (14) in the second direction (D2) being between a position of the first partial region (11) in the second direction (D2) and a position of the third partial region (13) in the second direction (D2), a position of the fifth partial region (15) in the second direction (D2) being between the position of the third partial region (13) in the second direction (D2) and a position of the second partial region (12) in the second direction (D2); and
a second semiconductor region (20) including Alₓ₂Ga₁₋ₓ₂N (0 < x2 < 1, x1 < x2), the second semiconductor region including a first semiconductor portion (21) and a second semiconductor portion (22), a direction from the fourth partial region (14) to the first semiconductor portion (21) being along the third direction (D3), a direction from the fifth partial region (15) to the second semiconductor portion (22) being along the third direction (D3), the second semiconductor portion (22) including a first region (22a) and a second region (22b), a position of the first region (22a) in the second direction (D2) being between a position of the second region (22b) in the second direction (D2) and the position of the second electrode (52) in the second direction (D2), a concentration of fluorine in the first region (22a) being higher than a concentration of fluorine in the second region (22b), or the first region (22a) including fluorine and the second region (22b) not including fluorine,
wherein
the second electrode (52) includes a first electrode portion (52a) and a second electrode portion (52b),
a direction from the first region (22a) to at least a part of the first electrode portion (52a) is along the second direction (D2), and
at least a part of the first region (22a) is provided between the first semiconductor region (10) and the second electrode portion (52b) in the third direction (D3),
further comprising:
a first insulating member (41),
**characterized in that** at least a part of the first insulating member (41) being provided between the first region (22a) and the second electrode portion (52b).

2. The device according to claim 1, wherein
a position of a boundary between the second region (22b) and the first region (22a) in the second direction (D2) is located between the position of the third electrode (53) in the second direction (D2) and a position of the second electrode portion (52b) in the second direction (D2).

3. The device according to claim 2, wherein
at least a part of the first region (22a) does not overlap the second electrode portion (52b) in the third direction (D3).

4. The device according to any one of claims 1 to 3, wherein
a part of the first region (22a) is provided between the second partial region (12) and the first electrode portion (52a) in the third direction (D3).

5. The device according to any one of claims 1 to 4, wherein
The second semiconductor portion (20) further includes a third region (22c),
the third region (22c) is provided between the second partial region (12) and the first electrode portion (52a) in the third direction (D3), and
a concentration of fluorine in the third region (22c) is lower than the concentration of fluorine in the first region (22a), or the third region (22c) does not include fluorine.

6. The device according to any one of claims 1 to 5, wherein
the second partial region (12) is in direct contact with the first electrode portion (52a), and
a direction from the second semiconductor portion (20) to at least a part of the first electrode portion (52a) is along the second direction (D2).

7. The device according to any one of claims 1 to 6, wherein
a part (41p) of the first insulating member (41) is provided between the first region (22a) and the second electrode portion (52b),
another part (41q) of the first insulating member (41) does not overlap the second electrode (52) in the third direction (D3), and
a thickness (t41p) of the part (41p) of the first insulating member along the third direction (D3) is thinner than the thickness (t41q) of the other part (41q) of the first insulating member along the third direction (D3).

8. The device according to any one of claims 1 to 7, wherein
the first insulating member includes a first insulating portion (41a) and a second insulating portion (41b),
at least a part of the first insulating portion (41a) is provided between the second semiconductor portion (20) and the second insulating portion (41b) in the third direction (D3),
the first insulating portion (41a) not overlapping the second electrode portion (52b) in the third direction (D3),
a part of the second insulating portion (41b) is provided between the first region (22a) and the second electrode portion (52b) in the third direction (D3), and
the part of the second insulating portion (41b) is provided between the first insulating portion (41a) and the first electrode portion (52a) in the second direction (D2).

9. The device according to claim 8, wherein
the second electrode (52) includes a nitride region (52N) and a conductive region (52C),
a part of the nitride region (52N) is provided between the second partial region (12) and the conductive region (52C),
another part of the nitride region (52N) is provided between the part of the second insulating portion (41b) and the second electrode portion (52b), and
the nitride region includes gallium and nitrogen.

10. The device according to any one of claims 1 to 9, wherein
at least a part of the third electrode (53) is provided between the first semiconductor portion (21) and the second semiconductor portion (22) in the second direction (D2).

11. The device according to any one of claims 1 to 10, further comprising:
a second electrode conductive member (52P) electrically connected to the second electrode (52); and
a second insulating member (42),
at least a part of the first insulating member (41) being provided between the second semiconductor portion (20) and the second electrode portion (52b),
at least a part of the second insulating member (42) being provided between the second electrode portion (52b) and the second electrode conductive member (52P),
the first insulating member (41) including silicon and nitrogen,
the second insulating member (42) including silicon and oxygen, and
a concentration of nitrogen in the second insulating member being lower than a concentration of nitrogen in the first insulating member, or the second insulating member not including nitrogen.

12. A method for manufacturing a semiconductor device, the method comprising:
preparing a structure body (10B), the structure body (10B) including a first semiconductor region (10) including Alₓ₁Ga₁₋ₓ₁N (0 ≤ x1 <1), a second semiconductor region (20) including Alₓ₂Ga_{1-x2N} (0 < x2 < 1, x1 < x2), and a first insulating film (41f; 41a), the second semiconductor region (20) includes a first region (22a) and a second region (22b), the second region (22b) being between the first semiconductor region (10) and the first insulating film (41f; 41a), the first region (22a) being not covered with the first insulating film (41f; 41a);
introducing fluorine into the first region (22a), a concentration of fluorine in the first region (22a) being higher than a concentration of fluorine in the second region (22b), or the first region (22a) including fluorine and the second region (22b) not including fluorine; and
forming an electrode (50;52) extending in a first direction (D1), the electrode (50; 52) including a first electrode portion (52a) and a second electrode portion (52b), the first electrode portion (52a) being electrically connected to a part of the first semiconductor region (10), the second electrode portion (52b) being electrically connected to the first electrode portion (52a), the second electrode portion (52b) at least overlapping the first region (22a) in a (third) direction (D3) from the first semiconductor region (10) to the second semiconductor region (20) perpendicular to the first direction (D1),
wherein
a direction from the first region (22a) to at least a part of the first electrode portion (52a) is along a second direction (D2) perpendicular to the first and third directions (D1, D3), further **characterized in that**
it comprises forming a second insulating film (42f; 41b) before forming the electrode (50; 52),
at least a part of the second insulating film (42f; 41b) being provided between the first region (22a) and the second electrode portion (52b).

13. The method of claim 12, wherein, the first insulating film (41f; 41a) is provided between the second region (22b) and a part of the second insulating film (42f; 41b), the first insulating film (41f; 41a) is not provided between the first region (22a) and the second insulating film (42f; 41b), the second insulating film (42f; 41b) includes fluorine, and the introducing the fluorine into the first region (22a) includes causing at least a part of the fluorine included in the second insulating film (42f; 41b) to move to the first region (22a).

## Patentansprüche

1. Halbleitervorrichtung mit:
einer ersten Elektrode (51), die sich in einer ersten Richtung (D1) erstreckt;
einer zweiten Elektrode (52), die sich in der ersten Richtung (D1) erstreckt, wobei eine zweite Richtung (D2) von der ersten Elektrode (51) zu der zweiten Elektrode (52) senkrecht zu der ersten Richtung (D1) ist;
einer dritten Elektrode (53), die sich in der ersten Richtung (D1) erstreckt, wobei eine Position der dritten Elektrode (53) in der zweiten Richtung (D2) zwischen einer Position der ersten Elektrode (51) in der zweiten Richtung (D2) und einer Position der zweiten Elektrode (52) in der zweiten Richtung (D2) ist,
einer ersten Halbleiterregion (10), die Alₓ₁Ga₁₋ₓ₁N (0 ≤ x1 < 1) aufweist, welche erste Halbleiterregion eine erste Teilregion (11), eine zweite Teilregion (12), eine dritte Teilregion (13), eine vierte Teilregion (14) und eine fünfte Teilregion (15) aufweist, wobei eine dritte Richtung (D3) von der ersten Teilregion (11) zu der ersten Elektrode (51) eine Ebene schneidet, die die erste Richtung (D1) und die zweite Richtung (D2) enthält, eine Richtung von der zweiten Teilregion (12) zu der zweiten Elektrode (52) entlang der dritten Richtung (D3) ist, eine Richtung von der dritten Teilregion (13) zu der dritten Elektrode (53) entlang der dritten Richtung (D3) ist, eine Position der vierten Teilregion (14) in der zweiten Richtung (D2) zwischen einer Position der ersten Teilregion (11) in der zweiten Richtung (D2) und einer Position der dritten Teilregion (13) in der zweiten Richtung (D2) ist, eine Position der fünften Teilregion (15) in der zweiten Richtung (D2) zwischen der Position der dritten Teilregion (13) in der zweiten Richtung (D2) und einer Position der zweiten Teilregion (12) in der zweiten Richtung (D2) ist; und
einer zweiten Halbleiterregion (20), die Alₓ₂Ga₁₋ₓ₂N (0 < x2 < 1, x1 < x2) aufweist, welche zweite Halbleiterregion (20) einen ersten Halbleiterabschnitt (21) und einen zweiten Halbleiterabschnitt (22) aufweist, wobei eine Richtung von der vierten Teilregion (14) zu dem ersten Halbleiterabschnitt (21) entlang der dritten Richtung (D3) ist, eine Richtung von der fünften Teilregion (15) zu dem zweiten Halbleiterabschnitt (22) entlang der dritten Richtung (D3) ist, der zweite Halbleiterabschnitt (22) eine erste Region (22a) und eine zweite Region (22b) aufweist, eine Position der ersten Region (22a) in der zweiten Richtung (D2) zwischen einer Position der zweiten Region (22b) in der zweiten Richtung (D2) und der Position der zweiten Elektrode (52) in der zweiten Richtung (D2) ist, eine Fluorkonzentration in der ersten Region (22a) höher ist als eine Fluorkonzentration in der zweiten Region (22b), oder die erste Region (22a) Fluor aufweist und die zweite Region (22b) kein Fluor aufweist, bei der
die zweite Elektrode (52) einen ersten Elektrodenabschnitt (52a) und einen zweiten Elektrodenabschnitt (52b) aufweist,
eine Richtung von der ersten Region (22a) zu mindestens einem Teil des ersten Elektrodenabschnitts (52a) entlang der zweiten Richtung (D2) ist, und
mindestens ein Teil der ersten Region (22b) zwischen der ersten Halbleiterregion (10) und dem zweiten Elektrodenabschnitt (52b) in der dritten Richtung (D3) vorgesehen ist,
weiter mit:
einem ersten Isolierelement (41),
**dadurch gekennzeichnet, dass**
mindestens ein Teil des ersten Isolierelements (41) zwischen der ersten Region (22a) und dem zweiten Elektrodenabschnitt (52b) vorgesehen ist.

2. Vorrichtung nach Anspruch 1, bei der
sich eine Position einer Grenze zwischen der zweiten Region (22b) und der ersten Region (22a) in der zweiten Richtung (D2) zwischen der Position der dritten Elektrode (53) in der zweiten Richtung (D2) und einer Position des zweiten Elektrodenabschnitts (52b) in der zweiten Richtung (D2) befindet.

3. Vorrichtung nach Anspruch 2, bei der
mindestens ein Teil der ersten Region (22a) nicht mit dem zweiten Elektrodenabschnitt (52b) in der dritten Richtung (D3) überlappt.

4. Vorrichtung nach einem der Ansprüche 1 bis 3, bei der
ein Teil der ersten Region (22a) zwischen der zweiten Teilregion (12) und dem ersten Elektrodenabschnitt (52a) in der dritten Richtung (D3) vorgesehen ist.

5. Vorrichtung nach einem der Ansprüche 1 bis 4, bei der
der zweite Halbleiterabschnitt (20) weiter eine dritte Region (22c) aufweist,
welche dritte Region (22c) zwischen der zweiten Teilregion (12) und dem ersten Elektrodenabschnitt (52a) in der dritten Richtung (D3) vorgesehen ist, und
eine Fluorkonzentration in der dritten Region (22c) niedriger ist als die Fluorkonzentration in der ersten Region (22a), oder die dritte Region (22c) kein Fluor aufweist.

6. Vorrichtung nach einem der Ansprüche 1 bis 5, bei der
die zweite Teilregion (12) in direktem Kontakt mit dem ersten Elektrodenabschnitt (52a) ist, und
eine Richtung von dem zweiten Halbleiterabschnitt (20) zu mindestens einem Teil des ersten Elektrodenabschnitts (52a) entlang der zweiten Richtung (D2) ist.

7. Vorrichtung nach einem der Ansprüche 1 bis 6, bei der
ein Teil (41p) des ersten Isolierelements (41) zwischen der ersten Region (22a) und dem zweiten Elektrodenabschnitt (52b) vorgesehen ist,
ein anderer Teil (41q) des ersten Isolierelements (41) nicht mit der zweiten Elektrode (52) in der dritten Richtung (D3) überlappt, und
eine Dicke (t41p) des Teils (41p) des ersten Isolierelements entlang der dritten Richtung (D3) dünner ist als die Dicke (t41q) des anderen Teils (41q) des ersten Isolierelements entlang der dritten Richtung (D3).

8. Vorrichtung nach einem der Ansprüche 1 bis 7, bei der
das erste Isolierelement einen ersten Isolierabschnitt (41a) und einen zweiten Isolierabschnitt (41b) aufweist,
mindestens ein Teil des ersten Isolierabschnitts (41a) zwischen dem zweiten Halbleiterabschnitt (20) und dem zweiten Isolierabschnitt (41b) in der dritten Richtung (D3) vorgesehen ist,
der erste Isolierabschnitt (41a) nicht den zweiten Elektrodenabschnitt (52b) in der dritten Richtung (D3) überlappt,
ein Teil des zweiten Isolierabschnitts (41b) zwischen der ersten Region (22a) und dem zweiten Elektrodenabschnitt (52b) in der dritten Richtung (D3) vorgesehen ist, und
der Teil des zweiten Isolierabschnitts (41b) zwischen dem ersten Isolierabschnitt (41a) und dem ersten Elektrodenabschnitt (52a) in der zweiten Richtung (D2) vorgesehen ist.

9. Vorrichtung nach Anspruch 8, bei der
die zweite Elektrode (52) eine Nitridregion (52N) und eine leitende Region (52C) aufweist,
ein Teil der Nitridregion (52N) zwischen der zweiten Teilregion (12) und der leitenden Region (52C) vorgesehen ist,
ein anderer Teil der Nitridregion (52N) zwischen dem Teil des zweiten Isolierabschnitts (41b) und dem zweiten Elektrodenabschnitt (52b) vorgesehen ist, und
die Nitridregion Gallium und Stickstoff aufweist.

10. Vorrichtung nach einem der Ansprüche 1 bis 9, bei der
mindestens ein Teil der dritten Elektrode (53) zwischen dem ersten Halbleiterabschnitt (21) und dem zweiten Halbleiterabschnitt (22) in der zweiten Richtung (D2) vorgesehen ist.

11. Vorrichtung nach einem der Ansprüche 1 bis 10, weiter mit:
einem zweiten leitenden Elektrodenelement (52P), das elektrisch mit der zweiten Elektrode (52) verbunden ist; und
einem zweiten Isolierelement (42), wobei
mindestens ein Teil des ersten Isolierelements (41) zwischen dem zweiten Halbleiterabschnitt (20) und dem zweiten Elektrodenabschnitt (52b) vorgesehen ist,
mindestens ein Teil des zweiten Isolierelements (42) zwischen dem zweiten Elektrodenabschnitt (52b) und dem zweiten leitenden Elektrodenelement (52P) vorgesehen ist,
das erste Isolierelement (41) Silizium und Stickstoff aufweist,
das zweite Isolierelement (42) Silizium und Sauerstoff aufweist, und
eine Stickstoffkonzentration in dem zweiten Isolierelement geringer ist als eine Stickstoffkonzentration in dem ersten Isolierelement, oder das zweite Isolierelement keinen Stickstoff aufweist.

12. Verfahren zum Herstellen einer Halbleitervorrichtung mit:
Vorbereiten eines Strukturkörpers (10B), welcher Strukturkörper (10B) eine erste Halbleiterregion (10), die Alₓ₁Ga₁₋ₓ₁N (0 ≤ x1 < 1) aufweist, eine zweite Halbleiterregion (20), die Alₓ₂Ga₁₋ₓ₂N (0 < x2 < 1, x1 < x2) aufweist, und einen ersten Isolierfilm (41f; 41a) aufweist, welche zweite Halbleiterregion (20) eine erste Region (22a) und eine zweite Region (22b) aufweist, welche zweite Region (22b) zwischen der ersten Halbleiterregion (10) und dem ersten Isolierfilm (41f; 41a) befindlich ist, welche erste Region (22a) nicht mit dem ersten Isolierfilm (41f; 41a) bedeckt ist;
Einbringen von Fluor in die erste Region (22a), wobei eine Fluorkonzentration in der ersten Region (22a) höher ist als eine Fluorkonzentration in der zweiten Region (22b), oder die erste Region (22a) Fluor aufweist und die zweite Region (22b) kein Fluor aufweist; und
Bilden einer Elektrode (50; 52), die sich in einer ersten Richtung (D1) erstreckt, welche Elektrode (50; 52) einen ersten Elektrodenabschnitt (52a) und einen zweiten Elektrodenabschnitt (52b) aufweist, welcher erste Elektrodenabschnitt (52a) mit einem Teil der ersten Halbleiterregion (10) elektrisch verbunden ist, welcher zweite Elektrodenabschnitt (52b) mit dem ersten Elektrodenabschnitt (52a) elektrisch verbunden ist, welcher zweite Elektrodenabschnitt (52b) mindestens die erste Region in einer (dritten) Richtung (D3) von der ersten Halbleiterregion (10) zu der zweiten Halbleiterregion (20) senkrecht zu der ersten Richtung (D1) überlappt, bei dem
eine Richtung von der ersten Region (22a) zu mindestens einem Teil des ersten Elektrodenabschnitts (52a) entlang einer zweiten Richtung (D2), die senkrecht zu den ersten und dritten Richtungen (D1; D3) ist, ist,
weiter **dadurch gekennzeichnet, dass** das Verfahren
Bilden eines zweiten Isolierfilms (42f; 41b) vor dem Bilden der Elektrode (50; 52) aufweist,
wobei mindestens ein Teil des zweiten Isolierfilms (42f; 41b) zwischen der ersten Region (22a) und dem zweiten Elektrodenabschnitt (52b) vorgesehen wird.

13. Verfahren nach Anspruch 12, bei dem
der erste Isolierfilm (41f; 41a) zwischen der zweiten Region (22b) und einem Teil des zweiten Isolierfilms (42f; 41b) vorgesehen wird,
der erste Isolierfilm (41f; 41a) nicht zwischen der ersten Region (22a) und dem zweiten Isolierfilm (42f; 41b) vorgesehen wird,
der zweite Isolierfilm (42f; 41b) Fluor aufweist, und
das Einführen des Fluors in die erste Region (22a) beinhaltet, mindestens einen Teil des Fluors, das der zweite Isolierfilm (42f; 41b) aufweist, zum Bewegen in die erste Region (22a) zu bringen.

## Revendications

1. Dispositif semi-conducteur comprenant :
une première électrode (51) s'étendant dans une première direction (D1) ;
une deuxième électrode (52) s'étendant dans la première direction (D1), une deuxième direction (D2) de la première électrode (51) à la deuxième électrode (52) étant perpendiculaire à la première direction (D1) ;
une troisième électrode (53) s'étendant dans la première direction (D1), une position de la troisième électrode (53) dans la deuxième direction (D2) étant comprise entre une position de la première électrode (51) dans la deuxième direction (D2) et une position de la deuxième électrode (52) dans la deuxième direction (D2) ;
une première région semi-conductrice (10) comprenant Alₓ₁Ga₁₋ₓ₁N (0 ≤ x1 < 1), la première région semi-conductrice comprenant une première région partielle (11), une deuxième région partielle (12), une troisième région partielle (13), une quatrième région partielle (14) et une cinquième région partielle (15), une troisième direction (D3) allant de la première région partielle (11) à la première électrode (51) traversant un plan comprenant la première direction (D1) et la deuxième direction (D2), une direction allant de la deuxième région partielle (12) à la deuxième électrode (52) étant le long de la troisième direction (D3), une direction allant de la troisième région partielle (13) à la troisième électrode (53) étant le long de la troisième direction (D3), une position de la quatrième région partielle (14) dans la deuxième direction (D2) étant comprise entre une position de la première région partielle (11) dans la deuxième direction (D2) et une position de la troisième région partielle (13) dans la deuxième direction (D2), une position de la cinquième région partielle (15) dans la deuxième direction (D2) étant comprise entre la position de la troisième région partielle (13) dans la deuxième direction (D2) et une position de la deuxième région partielle (12) dans la deuxième direction (D2) ; et
une deuxième région semi-conductrice (20) comprenant Alₓ₂Ga₁₋ₓ₂N (0 < x2 < 1, x1 < x2), la deuxième région semi-conductrice comprenant une première portion semi-conductrice (21) et une deuxième portion semi-conductrice (22), une direction allant de la quatrième région partielle (14) à la première portion semi-conductrice (21) étant le long de la troisième direction (D3), une direction allant de la cinquième région partielle (15) à la deuxième portion semi-conductrice (22) étant le long de la troisième direction (D3), la deuxième portion semi-conductrice (22) comprenant une première région (22a) et une deuxième région (22b), une position de la première région (22a) dans la deuxième direction (D2) étant comprise entre une position de la deuxième région (22b) dans la deuxième direction (D2) et la position de la deuxième électrode (52) dans la deuxième direction (D2), une concentration de fluor dans la première région (22a) étant supérieure à une concentration de fluor dans la deuxième région (22b), ou la première région (22a) comprenant du fluor et la deuxième région (22b) ne comprenant pas de fluor,
dans lequel la deuxième électrode (52) comprend une première portion d'électrode (52a) et une deuxième portion d'électrode (52b),
une direction allant de la première région (22a) à au moins une partie de la première portion d'électrode (52a) est le long de la deuxième direction (D2), et
au moins une partie de la première région (22a) est située entre la première région semi-conductrice (10) et la deuxième portion d'électrode (52b) dans la troisième direction (D3),
comprenant en outre :
un premier élément isolant (41),
**caractérisé en ce qu'**au moins une partie du premier élément isolant (41) étant entre la première région (22a) et la deuxième portion d'électrode (52b).

2. Dispositif selon la revendication 1, dans lequel
une position d'une limite entre la deuxième région (22b) et la première région (22a) dans la deuxième direction (D2) est située entre la position de la troisième électrode (53) dans la deuxième direction (D2) et une position de la deuxième portion d'électrode (52b) dans la deuxième direction (D2).

3. Dispositif selon la revendication 2, dans lequel
au moins une partie de la première région (22a) ne recouvre pas la deuxième portion d'électrode (52b) dans la troisième direction (D3).

4. Dispositif selon l'une quelconque des revendications 1 à 3, dans lequel une partie de la première région (22a) est prévue entre la deuxième région partielle (12) et la première portion d'électrode (52a) dans la troisième direction (D3).

5. Dispositif selon l'une quelconque des revendications 1 à 4, dans lequel la deuxième portion semi-conductrice (20) comprend en outre une troisième région (22c),
la troisième région (22c) est située entre la deuxième région partielle (12) et la première portion d'électrode (52a) dans la troisième direction (D3), et
une concentration de fluor dans la troisième région (22c) est inférieure à la concentration de fluor dans la première région (22a), ou la troisième région (22c) ne comprend pas de fluor.

6. Dispositif selon l'une quelconque des revendications 1 à 5, dans lequel la deuxième région partielle (12) est en contact direct avec la première portion d'électrode (52a), et une direction allant de la deuxième portion semi-conductrice (20) à au moins une partie de la première portion d'électrode (52a) est le long de la deuxième direction (D2).

7. Dispositif selon l'une quelconque des revendications 1 à 6, dans lequel une partie (41p) du premier élément isolant (41) est prévue entre la première région (22a) et la deuxième portion d'électrode (52b),
une autre partie (41q) du premier élément isolant (41) ne recouvre pas la deuxième électrode (52) dans la troisième direction (D3), et
une épaisseur (t41p) de la partie (41p) du premier élément isolant le long de la troisième direction (D3) est plus fine que l'épaisseur (t41q) de l'autre partie (41q) du premier élément isolant le long de la troisième direction (D3).

8. Dispositif selon l'une quelconque des revendications 1 à 7, dans lequel
le premier élément isolant comprend une première portion isolante (41a) et une deuxième portion isolante (41b),
au moins une partie de la première portion isolante (41a) est prévue entre la deuxième portion semi-conductrice (20) et la deuxième portion isolante (41b) dans la troisième direction (D3),
la première portion isolante (41a) ne recouvre pas la deuxième portion d'électrode (52b) dans la troisième direction (D3),
une partie de la deuxième portion isolante (41b) est prévue entre la première région (22a) et la deuxième portion d'électrode (52b) dans la troisième direction (D3), et
la partie de la deuxième portion isolante (41b) est prévue entre la première portion isolante (41a) et la première portion d'électrode (52a) dans la deuxième direction (D2).

9. Dispositif selon la revendication 8, dans lequel
la deuxième électrode (52) comprend une région de nitrure (52N) et une région conductrice (52C),
une partie de la région de nitrure (52N) est prévue entre la deuxième région partielle (12) et la région conductrice (52C),
une autre partie de la région de nitrure (52N) est prévue entre la partie de la deuxième portion isolante (41b) et la deuxième portion d'électrode (52b), et
la région de nitrure comprend du gallium et de l'azote.

10. Dispositif selon l'une quelconque des revendications 1 à 9, dans lequel au moins une partie de la troisième électrode (53) est prévue entre la première portion semi-conductrice (21) et la deuxième portion semi-conductrice (22) dans la deuxième direction (D2).

11. Dispositif selon l'une quelconque des revendications 1 à 10, comprenant en outre :
un deuxième élément conducteur d'électrode (52P) connecté électriquement à la deuxième électrode (52) ; et
un deuxième élément isolant (42),
au moins une partie du premier élément isolant (41) étant prévue entre la deuxième portion semi-conductrice (20) et la deuxième portion d'électrode (52b),
au moins une partie du deuxième élément isolant (42) étant prévu entre la deuxième portion d'électrode (52b) et le deuxième élément conducteur d'électrode (52P),
le premier élément isolant (41) comprenant du silicium et de l'azote,
le deuxième élément isolant (42) comprenant du silicium et de l'oxygène, et
une concentration d'azote dans le deuxième élément isolant inférieure à une concentration d'azote dans le premier élément isolant, ou le deuxième élément isolant ne comprenant pas d'azote.

12. Procédé de fabrication d'un dispositif semi-conducteur, comprenant les étapes consistant à :
préparer un corps de structure (10B), le corps de structure (10B) comprenant une première région semi-conductrice (10) comprenant Alₓ₁Ga₁₋ₓ₁N (0 ≤ x1 <1), une deuxième région semi-conductrice (20) comprenant Alₓ₂Ga₁₋ₓ₂N (0 < x2 < 1, x1 < x2), et un premier film isolant (41f ; 41a), la deuxième région semi-conductrice (20) comprend une première région (22a) et une deuxième région (22b), la deuxième région (22b) se trouvant entre la première région semi-conductrice (10) et le premier film isolant (41f ; 41a), la première région (22a) n'étant pas recouverte par le premier film isolant (41f ; 41a) ;
introduire du fluor dans la première région (22a), une concentration de fluor dans la première région (22a) étant supérieure à une concentration de fluor dans la deuxième région (22b), ou la première région (22a) comprenant du fluor et la deuxième région (22b) ne comprenant pas de fluor ; et
former une électrode (50;52) s'étendant dans une première direction (D1), l'électrode (50 ; 52) comprenant une première portion d'électrode (52a) et une deuxième portion d'électrode (52b), la première portion d'électrode (52a) étant connectée électriquement à une partie de la première région semi-conductrice (10), la deuxième portion d'électrode (52b) étant connectée électriquement à la première portion d'électrode (52a), la deuxième portion d'électrode (52b) chevauchant au moins la première région (22a) dans une (troisième) direction (D3) allant de la première région semi-conductrice (10) à la deuxième région semi-conductrice (20) perpendiculairement à la première direction (D1),
dans lequel
une direction allant de la première région (22a) à au moins une partie de la première portion d'électrode (52a) est le long d'une deuxième direction (D2) perpendiculaire aux première et troisième directions (D1, D3), **caractérisé en outre en ce qu'**il comprend former un deuxième film isolant (42f ; 41b) avant de former l'électrode (50 ; 52),
au moins une partie du deuxième film isolant (42f ; 41b) étant prévue entre la première région (22a) et la deuxième portion d'électrode (52b).

13. Procédé selon la revendication 12, dans lequel, le premier film isolant (41 f ; 41a) est prévu entre la deuxième région (22b) et une partie du deuxième film isolant (42f ; 41b), le premier film isolant (41 f ; 41 a) n'est pas prévu entre la première région (22a) et le deuxième film isolant (42f ; 41b), le deuxième film isolant (42f ; 41b) contient du fluor, et l'introduction du fluor dans la première région (22a) comprend le déplacement d'au moins une partie du fluor contenu dans le deuxième film isolant (42f ; 41b) vers la première région (22a).
